# EUROPEAN PATENT APPLICATION

(11) **EP 2 354 631 A2**
(43) Date of publication of application: **10.08.2011**
(21) Application number: 11151606.8
(22) Date of filing: 21.01.2011
(51) Int. Cl.: F21K 99/00, H01L 25/075, F21S 4/00, F21Y 103/00

(54) **LED Module and Backlight Unit having the Same**

(30) Priority: 26.01.2010 KR 20100007064
(71) Applicant: Samsung LED Co., Ltd., Gyunggi-do 442-743 (KR)
(72) Inventor: Ko, Kun Yoo, Gyunggi-do (KR); Choi, Seung Hwan, Gyunggi-do (KR); Lee, Won Joon, Seoul (KR); Kim, Jin Mo, Gyunggi-do (KR)
(74) Representative: Grünecker, Kinkeldey, Stockmair & Schwanhäusser Anwaltssozietät

(57) **Abstract**

There is provided an LED module, including a bar type circuit substrate formed with at least one groove so as to have a reflecting cup; a plurality of LED chips disposed in the groove of the circuit substrate and linearly arranged in a longitudinal direction of the circuit substrate; and a phosphor film spaced apart from the LED chips and disposed on the circuit substrate to cover the entire groove.

## Description

### CROSS-REFERENCE TO RELATED APPLICATIONS

This application claims the priority of Korean Patent Application No. 2010-0007064 filed on January 26, 2010, in the Korean Intellectual Property Office, the disclosure of which is incorporated herein by reference.

### BACKGROUND OF THE INVENTION

### Field of the Invention

The present invention relates to an LED module and a backlight unit having the same, and more particularly, to an LED module in a line light source and a backlight unit having the same.

### Description of the Related Art

With the recent trend for slimness and high performance in an image display device, a liquid crystal display device (LCD device) has been widely used in TVs, computer monitors, and the like. A liquid crystal panel cannot emit light by itself, such that it requires a separate light source unit, that is, a backlight unit (hereinafter, referred to as a 'BLU'). As a BLU light source, a cold cathode fluorescent lamp (CCFL) has previously been used. However, a light emitting diode (LED), which is advantageous in view of color representation, power consumption and the like, has recently been prominent as a BLU light source.

Generally, the BLU is divided into an edge-type BLU (side lighting type) and a direct-type BLU (direct lighting type). In the edge-type BLU, a bar-shaped light source is positioned on a side portion of a liquid crystal panel to irradiate light to the liquid crystal panel through a light-guide plate. On the other hand, in the direct-type BLU, light is directly emitted from a surface light source installed below the liquid crystal panel to the entire surface of a liquid crystal panel. The direct-type BLU includes optical members such as a surface light source disposed on a lower portion, diffusing plates disposed thereon having an interval, or the like.

In the edge-type BLU, an LED module provided with a plurality of white LEDs disposed on a bar-shaped circuit substrate having a predetermined interval from the LCD may be used as a BLU light source. Light from the white LEDs, incident on a light-guide plate, is transferred to a top of the light-guide plate through total reflection, scattering, or the like occurring within the light-guide plate. In the edge-type BLU, the LED module is disposed to be separate from the light-guide plate and to have a predetermined interval therebetween, so that light having uniform characteristics reaches a side portion of the light-guide plate. In particular, light emitted from the plurality of white LEDs, each corresponding to a point light source, is mixed at a predetermined distance or more. Therefore, an interval between the LED module and the light-guide plate is required so that uniform light reaches the light-guide plate. A production display device has a bezel width having a predetermined size due to the required interval, which increases the size of the area of the display product unnecessarily, and thus a reduction thereof is required.

In the direct-type BLU using an LED light source, a plurality of white LEDs or a combination of red, green and blue (RGB) LEDs are disposed below optical sheets such as a diffusion sheet, a prism sheet, and the like. A great number of LEDs are required in order to obtain a uniform surface light source, such that it causes an increase in manufacturing costs. When a small number of LEDs are used in order to reduce costs, dark portions or non-uniform color stains may be generated in a region between the LEDs. An interval between the LED and the optical sheet may be widened in order to prevent such a problem occurring. However, in this case, the thickness of the display device becomes thick, thereby being disadvantageous in the realization of product slimness.

### SUMMARY OF THE INVENTION

An aspect of the present invention provides an LED module capable of reducing a width of a bezel and implementing uniform line light source characteristics as an edge-type BLU light source. An aspect of the present invention also provides an edge-type backlight unit capable of reducing a width of a bezel and showing uniform light distribution characteristics.

In addition, an aspect of the present invention provides an LED module capable of removing dark portions and implementing uniform light distribution characteristics by having directional angles widened in a lateral direction together with uniform line light source characteristics. In addition, an aspect of the present invention also provides a direct-type backlight unit capable of implementing uniform light distribution characteristics and being appropriate for an impulsive driving method by sequential lighting.

According to an aspect of the present invention, there is provided an LED module, including: a bar type circuit substrate formed with at least one groove so as to have a reflecting cup; a plurality of LED chips disposed in the groove of the circuit substrate and linearly arranged in a longitudinal direction of the circuit substrate; and a phosphor film spaced apart from the LED chips and disposed on the circuit substrate to cover the entire groove.

The phosphor film may be made of a transparent resin containing phosphors. The LED module may emit white light by the plurality of LED chips and the phosphor film.

The at least one groove formed in the circuit substrate may be a single groove lengthened in a longitudinal direction of the circuit substrate and the plurality of LED chips may be arranged in the single groove in a row.

The at least one groove formed in the circuit substrate may be a plurality of grooves arranged in a longitudinal direction of the circuit substrate and at least one LED chip may be disposed in each of the plurality of grooves.

According to another aspect of the present invention, there is provided an edge-type backlight unit, including: a light-guide plate; and an LED module disposed at at least one side surface portion of the light-guide plate, wherein the LED module includes: a bar type circuit substrate formed with at least one groove so as to have a reflecting cup; a plurality of LED chips disposed in the groove of the circuit substrate and linearly arranged in a longitudinal direction of the circuit substrate; and a phosphor film spaced apart from the LED chips and disposed on the circuit substrate to cover the entire groove.

According to another aspect of the present invention, there is provided an LED module, including: a bar type circuit substrate; a plurality of LED chips linearly arranged on the circuit substrate in a longitudinal direction of the circuit substrate; a wavelength converter lengthened in a longitudinal direction of the circuit substrate so as to encapsulate the plurality of LED chips at a time; and a lens unit lengthened in a longitudinal direction of the circuit substrate so as to cover the wavelength converter and changing the paths of light emitted from the wavelength converter in a lateral direction.

The wavelength converter may be made of a transparent resin containing phosphors. The lens unit may have a dome shape in which a groove is extended in a center of an upper portion of the circuit substrate in a longitudinal direction of the circuit substrate. The LED module may emit white light by the plurality of LED chips and the wavelength converter.

According to another aspect of the present invention, there is provided a direct-type backlight unit, including: a bottom plate; and a plurality of LED modules arranged on the bottom plate having an interval therebetwen and each extended along a length of one side of the bottom plate, wherein each of the LED modules includes: a bar type circuit substrate lengthwise extended; a plurality of LED chips linearly arranged on the circuit substrate in a longitudinal direction of the circuit substrate; a wavelength converter lengthened in a longitudinal direction of the circuit substrate so as to encapsulate the plurality of LED chips at a time; and a lens unit lengthened in a longitudinal direction of the circuit substrate so as to cover the wavelength converter and changing the paths of the light emitted from the wavelength converter **in a lateral direction.**

### BRIEF DESCRIPTION OF THE DRAWINGS

The above and other aspects, features and other advantages of the present invention will be more clearly understood from the following detailed description taken in conjunction with the accompanying drawings, in which:

FIG. 1 is a plan view of an LED module that becomes a line light source according to an exemplary embodiment of the present invention;

FIG. 2 is a cross-sectional view taken along line A-A' of FIG. 1;

FIG. 3 is a diagram showing a main portion of an edge-type BLU using the LED module 100 of FIG. 1;

FIG. 4 is a plan view showing an LED module according to another exemplary embodiment of the present invention;

FIG. 5 is a cross-sectional view taken along line X-X' of FIG. 4;

FIG. 6 is a cross-sectional view taken along line Y-Y' of FIG. 4;

FIG. 7 is a plan view showing an LED module according to another exemplary embodiment of the present invention;

FIG. 8 is a cross-sectional view of the LED module of FIG. 7 taken along line B-B';

FIG. 9 is a perspective view showing a shape of a lens unit provided in the LED module of FIG. 7;

FIG. 10 is a diagram shown a main portion of a direct-type BLU using the LED module 500 of FIG. 7; and

FIG. 11 is a cross-sectional view of the direct-type BLU of FIG. 10 taken along line C-C'.

### DETAILED DESCRIPTION OF THE PREFERRED EMBODIMENT

Exemplary embodiments of the present invention will now be described in detail with reference to the accompanying drawings. The exemplary embodiments of the present invention may be modified in many different forms and the scope of the invention should not be limited to the embodiments set forth herein. In the drawings, the shapes and dimensions may be exaggerated for clarity, and the same reference numerals will be used throughout to designate the same or like components.

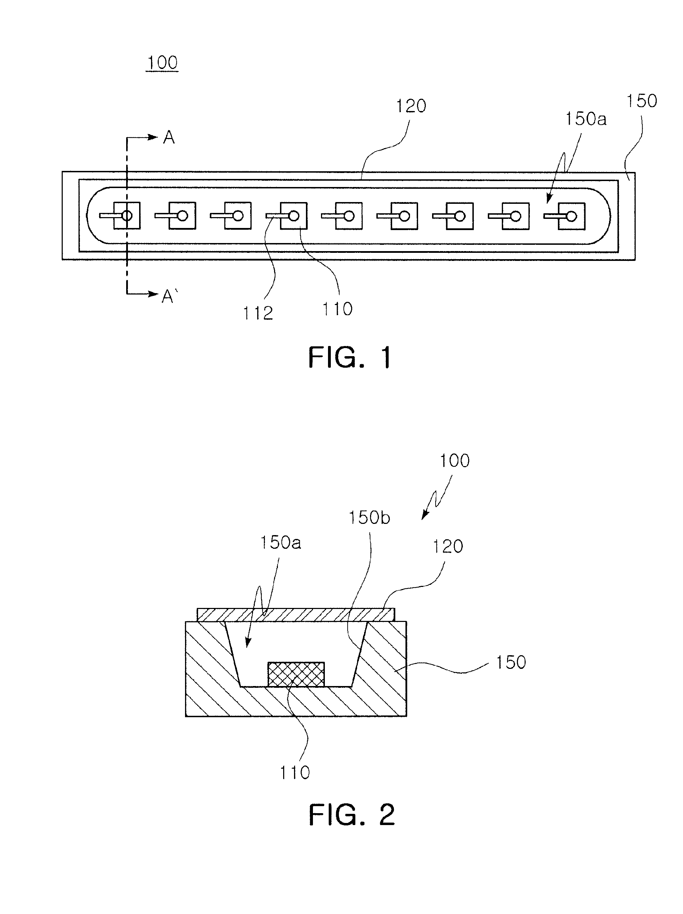

FIG. 1 is a plan view of an LED module that becomes a line light source according to an exemplary embodiment of the present invention and FIG. 2 is a cross-sectional view taken along line A-A' of FIG. 1. Referring to FIGS. 1 and 2, an LED module 100 includes a circuit substrate 150 such as a lengthwise extended bar type PCB, a plurality of LED chips 110, and a phosphor film 120. As shown in FIG. 2, the circuit substrate 150 has a groove 150a on the upper portion thereof so as to have a reflecting cup, wherein the plurality of LED chips 110 are linearly arranged in the groove 150a in a longitudinal direction of the circuit substrate 150. In particular, the groove 150a is formed of a single groove extended in a longitudinal direction of the circuit substrate 150 and the plurality of LED chips 110 are arranged in the single groove 150a in a row. A side wall 150b of the groove 150a functions as a reflective surface, thereby making it possible to reflect light emitted from the LED chips 110 in a desired emission direction.

The phosphor film 120 is disposed on the circuit substrate 150, while being separate from the LED chips 110 having an interval therebetween, so as to cover the entire groove 150a. Therefore, the phosphor film 120 is also formed to be extended lengthwise along the lengthwise extended groove 150a. The phosphor film 120 may be a transparent resin film containing phosphors converting light emitted from the LED chips 110 into light having a different wavelength. The LED module 100 may become a line light source emitting white light by the LED chips 110 and the phosphor film 120. A space between the LED chips 110 and the phosphor film 120 may be empty or may also be filled with a transparent resin so as to encapsulate the LED chips 110.

The plurality of LED chips 110 may be, for example, blue LED chips, and the phosphor film 120 may be a transparent resin containing phosphors excited by the blue light emitted from the blue LED chips to emit, for example, yellow light. The blue light emitted from the blue LED chips and the yellow light emitted from the phosphor film 120 are mixed, such that white light may be output. Therefore, the LED module 100 forms a line light source emitting white light. As another example, the plurality of LED chips 110 may be ultraviolet LED chips and the phosphor film 120 may be a transparent resin containing a combination of several kinds of phosphors (red phosphors, green phosphors, and blue phosphors) excited by ultraviolet rays to emit red, green, and blue light. The LED module 100 may form a line light source emitting white light by the ultraviolet LED chips and the phosphor film 120.

The circuit substrate 150 may be formed of, for example, a bar type PCB, and in particular, may be formed of a metal PCB so as to improve a heat dissipating effect. The LED chips 110 disposed in the groove 150a of the circuit substrate 150 may be bonded to the bottom of the groove 150a by die-bonding and may be electrically connected to a wiring or a leadframe (not shown) of the circuit substrate 150 by a bonding wire 112 by way of example. As another example, the LED chips 110 may be bonded to the bottom of the groove 150a by flip-chip bonding, without using separate wire bonding.

In the LED module 100, the plurality of LED chips 110 are arranged inside the groove 150a formed in a row so as to have a reflecting cup and a sheet of the phosphor film 120 is formed to cover the entire groove 150a, while being separate from the LED chips. Therefore, the LED module 100 can implement a line light source having uniform light characteristics directly on the phosphor film 120, unlike an existing point light source LED module. Therefore, it is possible to overcome a problem that an LED module used in the existing edge-type BLU should be separate from a light-guide plate at a predetermined distance so as to sufficiently mix light. Since the LED module 100 implements uniform line light source characteristics right on the phosphor film 120, an interval between the LED module 100 and the light-guide plate can be extremely narrowed when being applied to the edge-type BLU, thereby making it possible to remarkably reduce a width of a bezel in a LCD display.

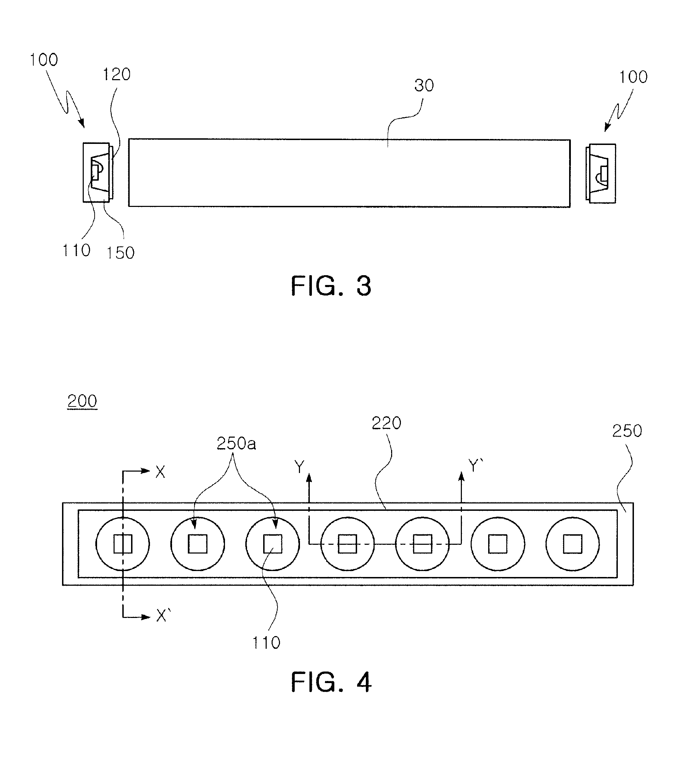

FIG. 3 is a diagram shown a main portion of an edge-type BLU using the LED module 100 of FIG. 1. Referring to FIG. 3, the edge-type BLU includes a light-guide plate 30 and the LED module 100 disposed on at least one side surface portion of the light-guide plate 30. The LED module 100 may be disposed at, for example, each of four side surface portions of the light-guide plate 30. The LED module 100 inputs light to the light-guide plate 30 and the light-guide plate 30 induces the light emitted from the LED module 100 to transfer it to a liquid crystal panel side on the light-guide plate 30. Optical sheets (not shown) such as a diffusion sheet, a prism sheet, or the like may be disposed on the light-guide plate 30. As described above, the LED module 100 including the circuit substrate 150 formed with the groove, the plurality of LED chips 110, and the phosphor film 120, is used as the line light source of the edge-type BLU, thereby making it possible to obtain more uniform light from the LED module 100 and reduce the width of the bezel in the display device since the interval between the LED module 100 and the side surface of the light-guide plate 30 can be further reduced.

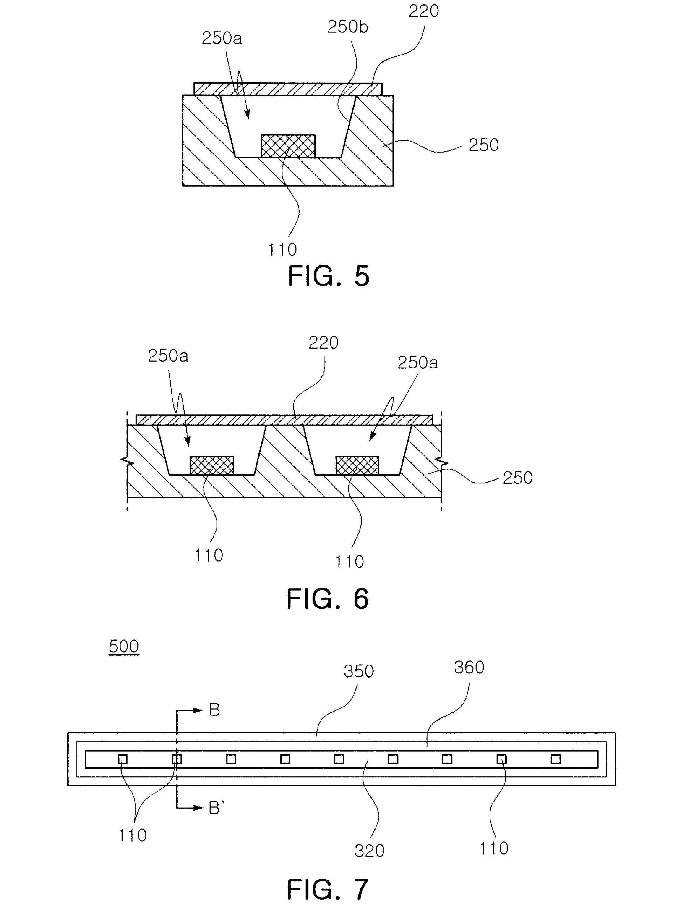

FIG. 4 is a plan view showing an LED module according to another exemplary embodiment of the present invention. FIG. 5 is a cross-sectional view taken along line X-X' of FIG. 4 and FIG. 6 is a cross-sectional view taken along line Y-Y' of FIG. 4. The present embodiment of the present invention describes a case in which a plurality of grooves 250a are formed on a bar type circuit substrate 250 and LED chips 110 are disposed in each of the grooves 250a. Referring to FIGS. 4 through 6, an LED module 200 includes a circuit substrate 250 such as a bar type PCB, a plurality of LED chips 110, and a phosphor film 220. The plurality of grooves 250a arranged in a longitudinal direction of the circuit substrate are formed in the circuit substrate 250 and at least one LED chip 110 (one in the present embodiment) is disposed in each of the groves 250a. Each groove 250a may have a side wall 250b and a groove bottom surface so as to form a reflecting cup and have a circular plan shape (see FIG. 4).

The phosphor film 220 is disposed on the circuit substrate 250, while being separate from the LED chips 110, so as to cover the entirety of the plurality of grooves 250a. As shown in FIG. 4, the phosphor film 220 is extended lengthwise by itself to cover the grooves 250a and converts a wavelength of light emitted from the LED chips 110 to allow the LED module 200 to emit white light. For example, the LED chips 110 emit blue light and the phosphor film 220 contains yellow phosphors excited by the blue light to emit yellow light, such that the entirety of the LED module 200 can output white light. As another example, the LED chips 110 emit ultraviolet rays and the phosphor film 220 contains a combination of phosphors excited by the ultraviolet rays to emit red, green, and blue light, such that the entirety of the LED module 200 can output white light.

The LED module 200 in the embodiment shown in FIGS. 4 through 6 also shows the uniform line light source characteristics. The LED module 200 is applied to the edge-type BLU, thereby making it possible to implement more uniform light distribution characteristics and a smaller width of a bezel. The LED module 200 can be applied to the edge-type BLU by disposing the LED module 200 shown in FIG. 4 at the side surface portion of the light-guide plate 30, instead of the LED module 100 shown in FIG. 3.

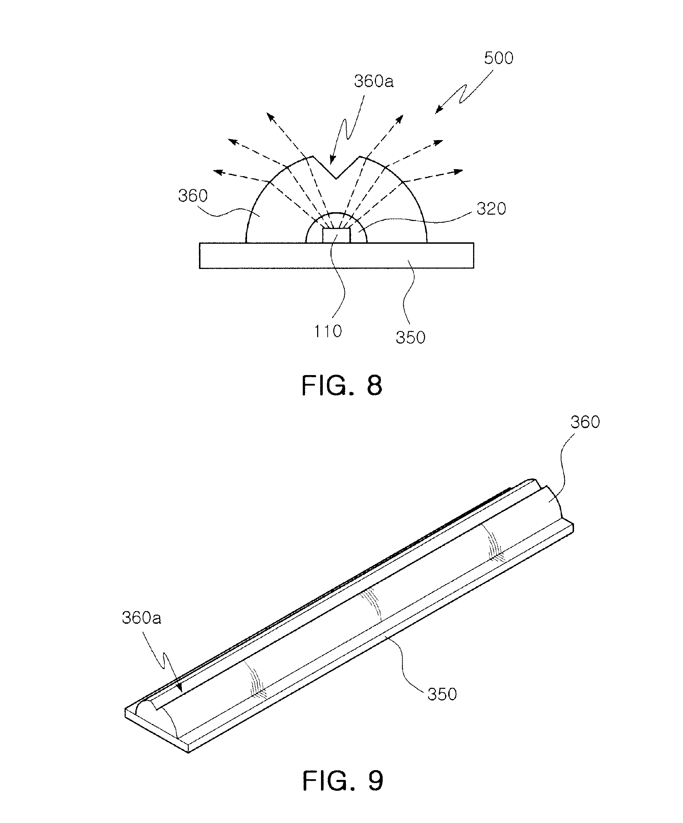

FIG. 7 is a plan view showing an LED module according to another exemplary embodiment of the present invention. FIG. 8 is a cross-sectional view of the LED module of FIG. 7 taken along line B-B' and FIG. 9 is a perspective view showing a shape of a lens unit provided in the LED module of FIG. 7. Referring to FIGS. 7 through 9, an LED module 500 includes a circuit substrate 350, a plurality of LED chips 110, a wavelength converter 320, and a lens unit 360. The circuit substrate 350 may be formed of, for example, a PCB or the like and may be extended lengthwise in a bar type. In particular, in order to discharge the heat generated from the LED chips 110 during the operation, a metal PCB may be used as the circuit substrate 350. The plurality of LED chips 110 are linearly arranged on the circuit substrate 350 in a longitudinal direction of the circuit substrate 350. The plurality of LED chips 110 are mounted on the circuit substrate 350 and are linearly (in a row) arranged thereon in a longitudinal direction of the circuit substrate 350. The LED chips 110 may be directly mounted on the circuit substrate 350 but an appropriate submount (not shown) on which the LED chips 110 are mounted may also be mounted on the circuit substrate 350.

The wavelength converter 320, which is a primary molding member, is lengthened in a longitudinal direction of the circuit substrate 350 so as to encapsulate the plurality of LED chips 110 at a time. The wavelength converter 320 converts a wavelength of the light emitted from the LED chips 110. The wavelength converter 320 may be made of a resin containing phosphors, which are excited by the light emitted from the LED chips 110 to emit visible light. For example, the LED chips 110 may be blue LED chips emitting blue light and the wavelength converter 320 may be a transparent resin containing yellow phosphors excited by the blue light emitted from the LED chips to emit yellow light. As another example, the LED chips 110 may be ultraviolet LED chips emitting ultraviolet rays and the wavelength converter 320 may be a transparent resin containing a combination of phosphors excited by the ultraviolet rays emitted from the LED chips to emit red, green, and blue light. The LED module 500 may output white light by the LED chips 110 and the wavelength converter 320. Separately, the plurality of LED chips 110 corresponding to a point light source are encapsulated with the wavelength converter 320 at a time, such that the LED module 500 itself may become a line light source having uniform light characteristics.

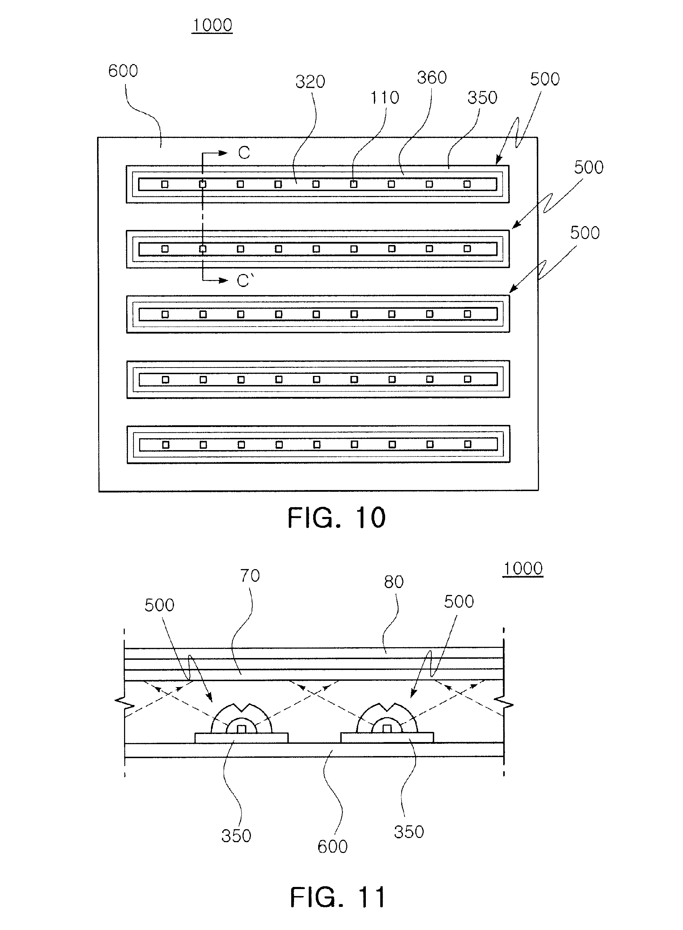

The lens unit 360, which is a secondary molding member, is lengthened in a longitudinal direction of the circuit substrate 350 so as to cover the wavelength converter. In particular, the lens unit 360 widens the directivity of the light in a lateral direction by changing the paths of the light emitted from the wavelength converter in a lateral direction (see dotted arrows schematizing paths of light in FIG. 8). As described below, owing to an expansion function of light directional angle in a lateral direction in the lens unit 360, the direct-type BLU (see reference numeral 1000 in FIG. 10) using the plurality of LED modules 500 provides a greater amount of light to a region between the LED modules to allow light to be mixed well in regions in which dark portions previously frequently occur. As clearly shown in FIGS. 8 and 9, the lens unit 360 has a dome shape in which a groove 360a is formed in a center of an upper portion or a semi-cylindrical shape. The groove 360a formed in the center of the upper portion of the lens unit 360 is extended over the entire length of the lens unit in a longitudinal direction of the circuit substrate 350. Owing to the dome shape in which such a grove 360a is formed, the lens unit 360 may expand the light directional angle in a lateral direction by changing the path of light in the lateral direction and for example, make the light directional angle 140° or more. The lens unit 360 may be formed by molding a transparent resin.

FIG. 10 is a diagram shown a main portion of a direct-type BLU using the LED module 500 of FIG. 7 and FIG. 11 is a cross-sectional view of the direct-type BLU of FIG. 10 taken along line C-C'.

Referring to FIGS. 10 and 11, the direct-type BLU 1000 includes a bottom plate 600 and a plurality of LED modules 500 arranged on the bottom plate 600 having an interval. An upper surface of the bottom plate 600 may be formed of a reflective surface. The bottom plate 600 may be, for example, a bottom cover member. The detailed configuration of the LED module 500 provided in the direct-type BLU 1000 is the same as that described with reference to FIGS. 7 through 9. Each of the LED modules 500 is lengthened along a length of one side (a long side of the bottom plate in the present embodiment) of the bottom plate 600 and several LED modules 500 are arranged in parallel at a predetermined interval. As described above, the LED module 500 itself provides uniform light characteristics of a line light source. Even though there is no light source in the region between the LED modules 500, a greater amount of light can be provided in the region between the LED modules due to the LED module 500's wide directional angle characteristics in a lateral direction and the light emitted from the adjacent LED modules 500 can be mixed well in the region between the modules. Therefore, the direct-type BLU 1000 can provide entirely uniform light distribution characteristics and provide uniform surface light to a liquid crystal panel (not shown) disposed thereon through optical members such as a diffusion plate 70, a prism sheet 80, or the like.

In addition, a separate light source of the direct-type BLU 1000 is provided as a line light source having a bar type circuit substrate, such that the sequential lighting of the plurality of LED modules 500 can be easily implemented by an impulsive driving method temporally synchronizing a BLU with a liquid crystal panel. The sequential lighting of the plurality of LED modules 500 arranged in parallel, which is an LED module design appropriate for the impulsive driving method, can be implemented. The impulsive driving method is applied, thereby making it possible to effectively eliminate screen afterimages of a LCD display.

As set forth above, according to exemplary embodiments of the invention, it is possible to reduce the width of the bezel, while making the light source characteristics of the edge-type backlight more uniform. Therefore, it is possible to effectively reduce unnecessary space or area of a LCD display product. In addition, according to exemplary embodiments of the invention, the direct-type backlight can make the light distribution characteristics uniform by providing light as much as possible to dark regions between line light sources by the LED modules and effectively eliminate screen afterimages by easily applying sequential driving.

While the present invention has been shown and described in connection with the exemplary embodiments, it will be apparent to those skilled in the art that modifications and variations can be made without departing from the spirit and scope of the invention as defined by the appended claims.

## Claims

1. An LED module, comprising:
a bar type circuit substrate formed with at least one groove so as to have a reflecting cup;
a plurality of LED chips disposed in the groove of the circuit substrate and linearly arranged in a longitudinal direction of the circuit substrate; and
a phosphor film spaced apart from the LED chips and disposed on the circuit substrate to cover the entire groove.

2. The LED module of claim 1, wherein the at least one groove formed in the circuit substrate is a single groove lengthened in a longitudinal direction of the circuit substrate and the plurality of LED chips are arranged in the single groove in a row.

3. The LED module of claim 1, wherein the at least one groove formed in the circuit substrate is a plurality of grooves arranged in a longitudinal direction of the circuit substrate and at least one LED chip is disposed in each of the plurality of grooves.

4. The LED module of claim 1, wherein the phosphor film is made of a transparent resin containing phosphors.

5. The LED module of claim 1, wherein the LED module emits white light by the plurality of LED chips and the phosphor film.

6. An edge-type backlight unit, comprising:
a light-guide plate; and
an LED module disposed at at least one side surface portion of the light-guide plate,
wherein the LED module includes:
a bar type circuit substrate formed with at least one groove so as to have a reflecting cup;
a plurality of LED chips disposed in the groove of the circuit substrate and linearly arranged in a longitudinal direction of the circuit substrate; and
a phosphor film spaced apart from the LED chips and disposed on the circuit substrate to cover the entire groove.

7. The edge-type backlight unit of claim 6, wherein the at least one groove formed in the circuit substrate is a single groove lengthened in a longitudinal direction of the circuit substrate and the plurality of LED chips are arranged in the single groove in a row.

8. The edge-type backlight unit of claim 6, wherein the at least one groove formed in the circuit substrate is a plurality of grooves arranged in a longitudinal direction of the circuit substrate and at least one LED chip is disposed in each of the plurality of grooves.

9. An LED module, comprising:
a bar type circuit substrate;
a plurality of LED chips linearly arranged on the circuit substrate in a longitudinal direction of the circuit substrate;
a wavelength converter lengthened in a longitudinal direction of the circuit substrate so as to encapsulate the plurality of LED chips at a time; and
a lens unit lengthened in a longitudinal direction of the circuit substrate so as to cover the wavelength converter and changing the paths of the light emitted from the wavelength converter in a lateral direction.

10. The LED module of claim 9, wherein the lens unit has a dome shape in which a groove is extended in a center of an upper portion of the circuit substrate in a longitudinal direction of the circuit substrate.

11. The LED module of claim 9, wherein the wavelength converter is made of a transparent resin containing phosphors.

12. The LED module of claim 9, wherein the LED module emits white light by the plurality of LED chips and the wavelength converter.

13. A direct-type backlight unit, comprising:
a bottom plate; and
a plurality of LED modules arranged on the bottom plate having an interval therebetween and each extended along a length of one side of the bottom plate,
wherein each of the LED modules includes:
a bar type circuit substrate lengthwise extended;
a plurality of LED chips linearly arranged on the circuit substrate in a longitudinal direction of the circuit substrate;
a wavelength converter lengthened in a longitudinal direction of the circuit substrate so as to encapsulate the plurality of LED chips at a time; and
a lens unit lengthened in a longitudinal direction of the circuit substrate so as to cover the wavelength converter and changing the paths of the light emitted from the wavelength converter in a lateral direction.

14. The direct-type backlight unit of claim 13, wherein the lens unit has a dome shape in which a groove extended in a longitudinal direction of the circuit substrate is formed in a center of an upper portion of the circuit substrate.
